# Europäisches Patentamt
## European Patent Office
## Office européen des brevets

(11) Publication number: **0 098 705**
**B1**

(12) **EUROPEAN PATENT SPECIFICATION**

(45) Date of publication of patent specification: **24.08.88**

(51) Int. Cl.⁴: **H 03 L 7/12, H 04 L 27/22**

(21) Application number: **83303503.3**

(22) Date of filing: **17.06.83**

(54) Phase lock loop circuit.

(30) Priority: **18.06.82 JP 105205/82**

(43) Date of publication of application:
**18.01.84 Bulletin 84/03**

(45) Publication of the grant of the patent:
**24.08.88 Bulletin 88/34**

(84) Designated Contracting States:
**DE FR GB IT NL**

(56) References cited:
**LU-A- 51 657**
**US-A-4 121 166**
**US-A-4 131 862**

(73) Proprietor: **FUJITSU LIMITED**
**1015, Kamikodanaka Nakahara-ku**
**Kawasaki-shi Kanagawa 211 (JP)**

(72) Inventor: **Takeda, Koichiro**
**Fujitsu Ltd. Patent Department 1015**
**Kamikodanaka**
**Nakahara-ku Kawasaki (JP)**

(74) Representative: **Sunderland, James Harry et al**
**HASELTINE LAKE & CO Hazlitt House**
**28 Southampton Buildings Chancery Lane**
**London WC2A 1AT (GB)**

Courier Press, Leamington Spa, England.

## Description

This invention relates to a phase lock loop circuit, and is especially concerned with a phase lock loop circuit for locking the phase of a recovered carrier to that of a received carrier of a PSK (Phase-Shift-Keying) signal.

In a synchronous detection system for demodulating a received PSK signal, there must be recovered a carrier which is phase-locked to a carrier of the received PSK signal.

Therefore, in a synchronous detecting system of this type, an output obtained by detecting a received PSK signal using a recovered carrier is subjected to logical processing in order to remove phase components. The output signal is then applied to a voltage controlled oscillator as a phase error signal and the phase of the recovered carrier, which carrier is output from the voltage controlled oscillator, is locked to the phase of a received PSK signal.

In an ordinary phase lock loop circuit, a high performance loop, which is less affected by disturbances, can be obtained by narrowing the loop bandwidth, but an excessively narrow loop bandwidth will invite deterioration of tracking characteristics with respect to the received PSK signal.

US—A—4 131 862 discloses a phase lock loop operable with narrow band filtering characteristics when in a locked-in condition, and with wideband acquisition characteristics when in an out-of-lock condition. A narrow band filter and a wide band filter are provided. In an out-of-lock condition the narrow band filter is taken out of operation and a step ramp voltage is used to vary the frequency of a voltage controlled oscillator until lock-in is achieved. After lock-in is achieved the step ramp voltage level is held and the nrrow band filter brought back into operation.

There has been proposed another method, intended to ensure stable circuit operation with excellent tracking characteristics and narrow loop bandwidth, in which method a specified rectangular wave sweep signal employed for providing a signal superimposed on a phase error signal as mentioned above in order to control the voltage controlled oscillator of the phase lock loop circuit until synchronous operation of the circuit is established, and in which method supply of the rectangular sweep signal is suspended after synchronous operation is established.

However, the method in which a superimposed rectangular wave sweep signal is employed has involved the generation of an extra sweep signal component at the time of suspending superimposition of such sweep signal, accordingly giving rise to a disturbance of the phase lock loop.

According to the present invention there is provided a phase lock loop circuit comprising a voltage controlled oscillator arranged to be controlled in dependence upon a phase error signal, a sweep signal generator operable to generate a rectangular wave sweep signal (a), a select circuit operable to receive the sweep signal and to deliver the sweep signal to one terminal of a capacitor the other terminal of which is connected to means for superimposing an output level of the capacitor on the phase error signal, thereby to sweep the voltage controlled oscillator by the superimposition of a pseudo 3-level signal, provided from the capacitor, on the phase error signal, the selector circuit being operable to suspend such delivery of the sweep signal when phase lock is achieved, characterised in that the selector circuit is operable, upon achievement of phase lock, to maintain delivery, to the said one terminal of the capacitor, of the level of the sweep signal immediately before such achievement.

Embodiments of the present invention provide phase lock loops which do not generate unwanted sweep signal components and which require only simple circuit structures.

An embodiment of the present invention can provide a phase lock loop which has excellent tracking characteristics for a received PSK signal, and also has stable oerations.

An embodiment of the present invention provides for the prevention of generation of unwanted sweep signal components in a phase locking method using a sweep signal.

Reference is made, by way of example, to the accompanying drawings, in which:—

Figure 1 is a schematic block diagram of a previously proposed phase lock loop in which a sweep signal is superimposed on a phase error signal generated by a baseband processing circuit of the loop,

Figure 2 is a waveform diagram illustrating output waveforms of main circuit elements of the loop illustrated in Figure 1,

Figure 3 is a schematic block diagram of phase lock loop embodying the present invention in which sweep signal supply is controlled by a selector circuit,

Figure 4 is a waveform diagram illustrating output waveforms of main circuit elements of the loop illustrated in Figure 2,

Figure 5 is a logical circuit diagram of one form of selector circuit that can be employed in an embodiment of the present inveniton, and

Figure 6 is a logical circuit diagram of another form of selector circuit that can be employed in an embodiment of the present invention.

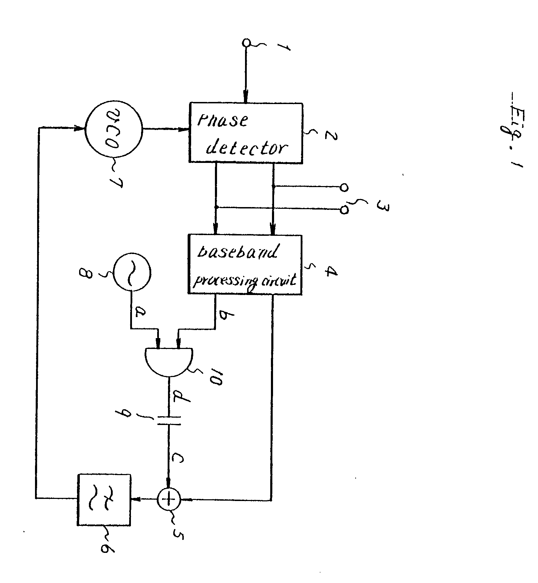

In Figure 1, 1 is an input terminal for a received PSK signal; 2 is a phase detector; 3 indicates output terminals for demodulated data; 4 is a baseband processing circuit; 5 is an adder; 6 is a loop (shown as a low-pass) filter; 7 is a voltage controlled oscillator; 8 is a sweep oscillator; 9 is a coupling capacitor; and 10 is an AND gate.

Assuming that the received PSK signal is a 4-level PSK signal, the phase detector 2 synchronously detects the 4-level PSK signal on the basis of a recovered carrier as supplied from an output of the voltage controlled oscillator 7 and the recovered carrier as phase-shifted by 90 degrees, then demodulates data from the PSK signal and provides an output of demodulated data at the output terminals 3. Such data ·is applied to the baseband processing circuit 4 and baseband processing circuit 4 outputs a phase error signal and a decision signal $b$ which indicates whether or not the loop is phase-locked.

As the phase error signal, for example in the case of the synchronous detection of a 4-level PSK signal indicated by sin $(\theta+n/4 . \pi)$, there is used a sin$4\theta$ signal obtained by 4-times frequency multiplication of such a signal by the baseband processing circuit 4 and by removal of phase components therefrom.

As the decision signal $b$, moreover, a signal having values "1" and "0" is used. These values are obtained by integrating a cos$4\theta$ signal, which is obtained as a signal having a phase difference of 90 degrees from the pertinent sin$4\theta$ signal, and then by comparing the integrated value with a specified threshold level. The cos$4\theta$. signal becomes equal to 1 when $\theta=0$ in a perfect phase locked state and becomes equal to about 0.5 where detection is carried out in respect to a non-phase-locked random signal. For example, therefore, when the specified threshold level is selected to a value of 0.75 and a value larger than such threshold level is obtained in respect of the integrated cos$4\theta$ signal, a signal value "0" is output as the decision signal $b$-indicating the phase locked state—and when a value smaller than the threshold level is obtained a signal value "1" is output as the decision signal $b$-indicating a non-phase locked state, respectively.

The phase error signal is applied as a control signal to the voltage controlled oscillator 7 via the loop filter 6 from the adder circuit 5, and the phase of the recovered carrier as provided from an output of the voltage controlled oscillator 7 is locked to the carrier phase of the received PSK signal applied to the input terminal.

As mentioned above, the decision signal $b$ sent from the baseband processing circuit 4 is of value "1" in the non-locked condition and of value "0" in the locked condition. Therefore, the sweep signal $a$ sent from the sweep oscillator 8 is not applied to the voltage controlled oscillator 7 in the locked condition and the phase lock loop operates so that the phase error signal becomes zero. In the non-locked condition, the sweep signal $a$ is applied to the adder circuit 5 via the AND gate 10 and capacitor 9 and it is then applied via the loop filter 6 to the voltage controlled oscillator 7, as a control signal therefor, together with the phase error signal. Therefore, is the non-locked condition the output frequency of the voltage controlled oscillator 7 is swept until it is set to a pull-in condition.

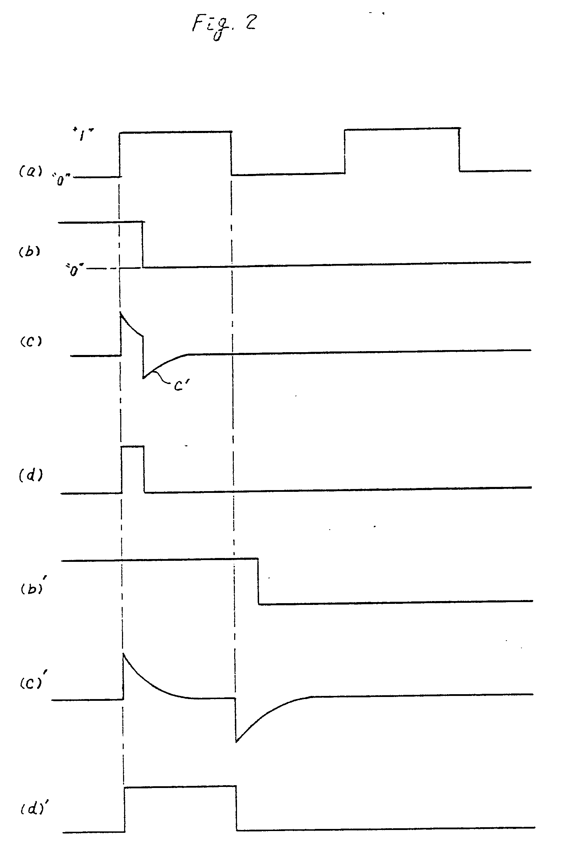

Figure 2 illustrates signal waveforms relating to the loop of Figure 1. The sweep signal $a$ is indicated at waveform (a), the decision signal $b$ at waveform (b), a signal $c$ applied to the adder 5 via capacitor 9 at waveform (c) and the output signal $d$ of AND gate 10 at waveform (d).

The sweep signal $a$ takes values "1" and "0" repeatedly, with a constant repeat period as shown in waveform (a) and is applied to the phase lock loop via the AND gate 10 when the decision signal $b$ has value "1" indicating a non-locked state. The capacitor 9 is provided in order to eliminate DC coupling between the output of AND gate 10 and the phase lock loop and to output a pseudo 3-level signal. That is, a sweep in both positive and negative directions becomes possible by applying the sweep signal, consisting of a rectangular wave signal, to the loop through the capacitor 9.

When the decision signal $b$ changes to the locked condition value "0", from the non-locked condition value "1", the output of AND gate 10 becomes "0" independently of the level of sweep signal $a$. Therefore, when the decision signal $b$ changes to "0" while the sweep signal $a$ is "1", an extra signal component $c'$ occurs, as shown in Figure 2(c) through charging and discharging of the capacitor 9. Because of this extra signal component, a pull-in state is sometimes destroyed just as when such a pull-in state is broken by a disturbance.

Figure 2(b)', (c)', and (d)' respectively show further examples of waveforms of the decision signal $b$, output signal $c$ of capacitor 9 and output signal $d$ of AND gate 10 and in this case since the decision signal $b$ becomes "0" when the sweep signal $a$ is "0", the signal applied to the phase lock loop is applied as a pseudo 3-level signal, and no problem arises.

Thus, a defect has been observed such that if phase is locked and sweep stops when the sweep signal $a$ is "1", an extra sweep signal $c'$ is generated, giving rise to a disturbance of the phase lock loop.

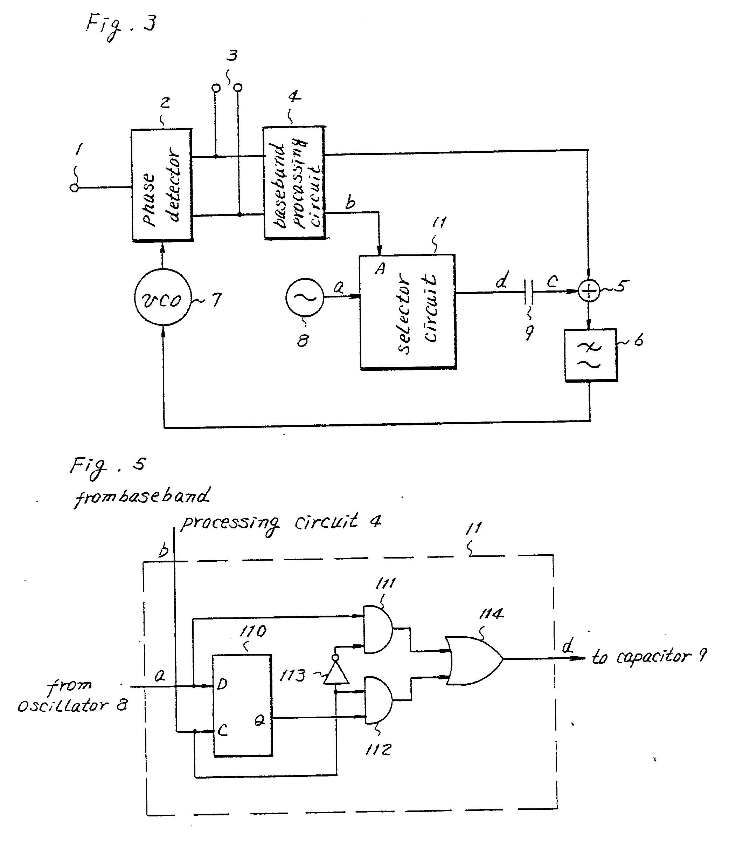

Figure 3 is a schematic block diagram of an embodiment of the present invention. The same reference numerals and letters as are used in Figure 1 indicate similar circuit elements and signals and 11 is a selector circuit.

At a terminal A the selector circuit 11 receives the decision signal $b$ sent from the baseband processing circuit 4 at the terminal A and outputs a signal $d$ of similar purpose to signal $d$ of Figure 1 but taking different values as indicated below. When the decision signal $b$ is "1", the sweep signal $a$, which is output from the sweep oscillator 8, is directly output from the selector circuit and when the decision signal $b$ is "0", output level is determined in dependence upon the level of output signal $d$ obtained while the decision signal $b$ has changed to "0" from "1". Namely, when "0" was being output when the decision signal $b$ changed to "0", "0" is output after the change and when "1" was being output, "1" is output after the change, respectively. In other words, when the decision signal $b$ changes to "0", the immediately preceding condition of output $d$ is maintained after the change and the truth value table of the selector circuit 11 is as indicated in Table 1.

TABLE 1

| b | a | $d^{-1}$ | d |
|---|---|---|---|
| 0 | 0 | 0 | 0 |
| 0 | 0 | 1 | 1 |
| 0 | 1 | 0 | 0 |
| 0 | 1 | 1 | 1 |
| 1 | 0 | 0 | 0 |
| 1 | 0 | 1 | 0 |
| 1 | 1 | 0 | 1 |
| 1 | 1 | 1 | 1 |

In Table 1, $b$ refers to the changed value (i.e. the value after the change) of the decision signal $b$, $a$ refers to the signal $a$ generated from the sweep generator 8; $d^{-1}$ refers to the output $d$ of the selector circuit 11 just before the decision signal $b$ changes, and refers $d$ to the output $d$ from the selector circuit 11, respectively.

When the initial value of decision signal $b$ is "0" (and the changed value "1") the value of $d^{-1}$ is uncertain and the output $d$ of selector circuit 11 after the change is also uncertain (depends on $a$).

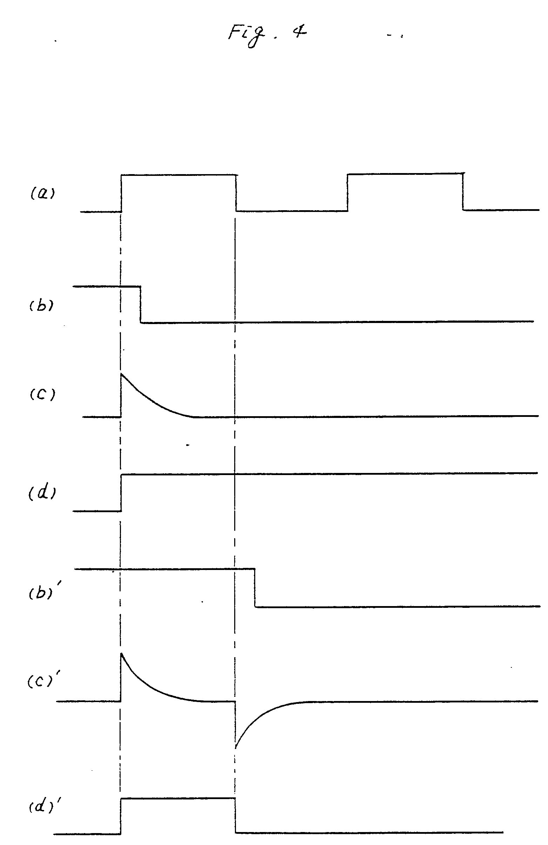

Figure 4 illustrates signal waveforms relating to the loop of Figure 3. When the sweep signal $a$—waveform (a)— is "1", the output signal $d$ of the selector circuit 11 is held to "1"—as shown in waveform (d)—when the decision signal $b$ changes from "1" to "0"—as shown waveform (b). Thereby the output signal $c$ of the capacitor 9 does not generate extra sweep signal components (see Figure 2)—as evidenced by waveform (c).

As shown by waveform (b)' of Figure 4, when the decision signal $b$ changes from "1" to "0" while the sweep signal $a$ is "0", the output signal $d$ of the selector circuit 11 becomes "0" as shown in waveform (d)' and the output signal $c$ of capacitor 9 is as indicated in waveform (c)'. In this case, the signal waveforms obtained are the same as waveforms (b)' to (d)' of Figure 2.

As explained above, with the change of $b$ from "1" to "0" the output signal $d$ of the selector circuit 11 holds the state "1" even when the sweep signal $a$ is "1" (compare Figure 2, waveform (d)) the non-lock state changes to locked state and thereby the sweep stops. Therefore, the unwanted sweep signal component which has been observed in previously proposed loops is not generated and thereby the phase lock condition can be maintained.

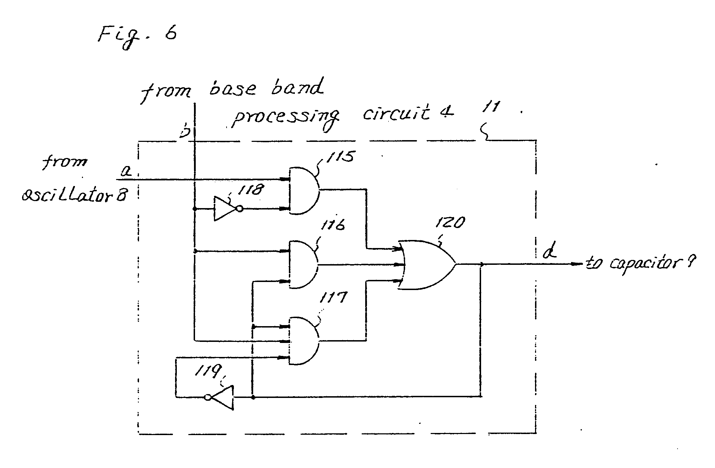

The selector circuit 11 shown in Figure 3 can easily be formed by logic circuits based on the truth table shown in Table 1 and one structure for such a circuit 11 is shown in Figure 5.

In Figure 5, 110 is a flip-flop; 111, 112 are AND gates; 113 is an invertor; and 114 is an OR gate.

The decision signal $b$ generated by the baseband processing circuit 4 is input to a terminal C of the flip-flop 110, to invertor 113 and to AND gate 112, whilst the sweep signal $a$ generated by the sweep oscillator 8 is input to a teerminal D of flip-flop 110 and to AND gate 111. The output of the OR gate 114 provides the output $d$ of the selector circuit 11.

Figure 6 illustrates another structure for such a selector circuit 11. In Figure 6, 115, 116 and 117 are AND gates; 118 and 119 are invertors; and 120 is an OR gate. The decision signal $b$ generated from the baseband processing circuit 4 is input to the invertor 118 and to AND gates 116 and 117, whilst the sweep signal $a$ generated from the sweep oscillator 8 is input to the AND gate 115. The output of the OR gate 120 provides an output $d$ of the selector circuit 11.

More practically, Motorola's CMOS-IC MC14052B can be adopted as said selector circuit 11.

As explained above, an embodiment of the present invention provides that sweeping is suspended in accordance with a decision signal which indicates the phase lock state and that the level of sweep signal $a$ just before the phase lock state is achieved is held and is applied to the phase lock loop at the time of achievement of phase lock. Pulling in of phase involves sweeping the voltage controlled oscillator 7 by means of the sweep oscillator 8 in the phase lock loop circuit to recover carrier for demodulation of the PSK signal. The embodiment of this invention provides that an unwanted signal is not generated when the sweep stops and moreover that stable phase lock operation can be realized.

It is of course possible to arrange the loop circuit so that the decision signal $b$ is "0" in the non-lock state and "1" for the locked state, different from the described embodiment. In such a case, the logic structure of the selector circuit must be formed to correspond to the logic of the decision signal.

An embodiment of the present invention discloses a phase lock loop circuit for recovering a carrier for demodulating a PSK signal. A voltage controlled oscillator is swept by means of a sweep generator. A sweep signal is suspended in accordance with a decision signal which indicates that a phase locked state is achieved and the immediately preceding level of the sweep signal is held and applied to the phase lock loop at the timing of phase-lock pull-in. Thereby an unwanted sweep signal component is no longer generated when sweep stops and stable phase lock operation can be realized.

**Claims**

1. A phase lock loop circuit comprising a voltage controlled oscillator (7) arranged to be controlled in dependence upon a phase error signal, a sweep signal generator (8) operable to generate a rectangular wave sweep signal ($a$), a select circuit (11) operable to receive the sweep signal and to deliver the sweep signal to one terminal of a capacitor (9) the other terminal of which is connected to means (5) for superimposing an output level of the capacitor on the phase error signal, thereby to sweep the voltage controlled oscillator by the superimposition of a pseudo 3-level signal, provided from the capacitor, on the phase error signal, the selector circuit being operable to suspend such delivery of the sweep signal when phase lock is achieved, characterised in that the selector circuit (11) is operable, upon achievement of phase lock, to maintain delivery, to the said one terminal of the capacitor, of the level of the sweep signal (a) immediately before such achievement.

2. A phase lock loop circuit as claimed in claim 1, comprising:

an input terminal (1) for receiving a phase shift keying signal;

a phase detector (2) connected to the input terminal (1), for synchronously detecting the phase shift keying signal on the basis of a recovered carrier signal;

a baseband processing circuit (4) connected to the phase detector (2), for processing an output signal of the phase detector (2), and for providing the phase error signal and a decision signal (b) which indicates whether or not the loop is phase-locked;

wherein the selector circuit (11) is supplied with the decision signal (b) and the sweep signal (a), and is operable to suspend delivery of the sweep signal (a) to said one terminal of the capacitor (9) when the decision signal (b) indicates that the loop is phase-locked, but is operable to maintain delivery of the level of the sweep signal (a) just before the decision signal provided such indication.

3. A phase lock loop circuit as claimed in claim 2, wherein the phase shift keying signal which is supplied to the input terminal is a 4-level PSK signal.

4. A phase lock loop circuit as claimed in claim 1, 2 or 3 wherein the sweep signal is a square wave signal.

## Patentansprüche

1. Phasenrastungsschleifenschaltung mit einem spannungsgesteuerten Oszillator (7), der angeordnet ist, um in Abhängigkeit von einem Phasenfehlersignal gesteuert zu werden, mit einem Wobbelsignalgenerator (8), der betreibbar ist, um ein Rechteckwellen-Wobbelsignal (a) zu erzeugen, einer Auswahlschaltung (11), die betreibbar ist, um das Wobbelsignal zu empfangen und das Wobbelsignal einem Anschluß eines Kondensators (9) zuzuführen, dessen anderer Anschluß mit einer Einrichtung (5) verbunden ist, zum Überlagern eines Ausgangspegels des Kondensators mit dem Phasenfehlersignal, um dadurch den spannungsgesteuerten Oszillator durch Überlagerung eines Pseudo-3-Pegel-Signals, welches von dem Kondensator geliefert wird, mit dem Phasenfehlersignal zu wobbeln, wobei die Auswahlschaltung betreibbar ist, um eine solche Lieferung des Wobbelsignals zu suspendieren, wenn die Phasenrastung erreicht ist, dadurch gekennzeichnet, daß die Auswahlschaltung (11) bei Erreichung der Phasenrastung betreibbar ist, um zu dem genannten einen Anschluß des Kondensators die Lieferung des Pegels des Wobbelsignals (a) unmittelbar vor solch einer Erreichung aufrechtzuerhalten.

2. Phasenrastungsschleifenschaltung nach Anspruch 1, mit:

einem Eingangsanschluß (1) zum Empfangen eines Phasenverschiebungs-Tastsignals;

einem Phasendetektor (2), der mit dem Eingangsanschluß (1) verbunden ist, um synchron das Phasenverschiebungs-Tastsignal auf der Basis eines wiedergewonnenen Trägersignals au detektieren;

einer Basisband-Verarbeitungsschaltung (4) die mit dem Phasendetektor (2) verbunden ist, um ein Ausgangssignal des Phasendetektors (2) zu verarbeiten, und um das Phasenfahlersignal und ein Entscheidungssignal (b), welches anzeigt, ob die Schleife phasenstarr ist oder nicht, zu liefern;

bei welcher der Auswahlschaltung (11) das Entscheidungssignal (b) und das Wobbelsignal (a) zugeführt wird, und welche betreibbar ist, um die Lieferung des Wobbelsignals (a) zu dem einen Anschluß des Kondensators (9) zu suspendieren, wenn das Entscheidungssignal (b) anzeigt, daß die Schleife phasenstarr ist, die jedoch betreibbar ist, um die Lieferung des Pegels des Wobbelsignals (a) unmittelbar vor dem Entscheidungssignal, das durch eine solche Anzeige geliefert wird, aufrechtzuerhalten.

3. Phasenrastungsschleifenschaltung nach Anspruch 2, bei welcher das Phasenverschiebungs-Tastsignal, welches zu dem Eingangsanschluß geliefert wird, ein 4-Pegel-PSK-Signal ist.

4. Phasenrastungsschleifenschaltung nach Anspruch 1, 2 oder 3, bei welcher das Wobbelsignal ein Rechteckwellensignal ist.

## Revendications

1. Circuit de boucle à verrouillage de phase, comportant un oscillateur commandé par tension (7) agencé pour être commandè en fonction d'un signal d'erreur de phase, un générateur de signal de balayage (8) ayant pour fonction de produire un signal de balayage de forme rectangulaire (a), un circuit de sélection (11) ayant pour fonction de recevoir le signal de balayage et de délivrer ce signal de balayage à une borne d'un condensateur (9) dont l'autre borne est connectée à un dispositif (5) de superposition d'un niveau de sortie du condensateur sur le signal d'erreur de phase, de manière à balayer l'oscillateur commandé par tension par la superposition d'un pseudo-signal à trois niveaux, produit par le condensateur, sur le signal d'erreur de phase, le circuit de sélection ayant pour fonction de suspendre cette application du signal de balayage quand le verrouillage de phase est atteint,

**0 098 705**

caractérisé en ce que le circuit de sélection (11) a pour fonction, quand le verrouillage de phase est obtenu, de maintenir l'application à ladite borne du condensateur du niveau du signal de balayage (a) immédiatement avant que ce verrouillage soit atteint.

2. Circuit de boucle à verrouillage de phase selon la revendication 1, comportant:

une borne d'entrée (1) destinée à recevoir un signal de manipulation par déplacement de phase;

un détecteur de phase (2) connecté à la borne d'entrée (1) pour détecter en synchronisme le signal de manipulation par déplacement de phase sur la base d'un signal de porteuse récupérée;

un circuit de traitement de bande de base (4) connecté au détecteur de phase (2) pour traiter un signal de sortie de ce détecteur de phase (2) et pour produire le signal d'erreur de phase et un signal de décision (b) qui indique si la boucle est verrouillée en phase ou non:

dans lequel le circuit de sélection (11) reçoit le signal de décision (b) et le signal de balayage (a) et a pour fonction de suspendre l'application du signal de balayage (a) à ladite borne du condensateur (9) quand le signal de décision (b) indique que la boucle est verrouillée en phase mais a également pour fonction de maintenir l'application de niveau du signal de balayage (a) juste avant que le signal de décision fournisse cette indication.

3. Circuit de boucle à verrouillage de phase selon la revendication 2, dans lequel le signal de manipulation par déplacement de fréquence qui est appliqué la borne d'entrée est un signal PSK à quatre niveaux.

4. Circuit de boucle à verrouillage de phase selon la revendication 1, 2 ou 3 dans lequel le signal de balayage est un signal rectangulaire.

_Fig. 1_

Fig. 2

Fig. 3

Fig. 5

from baseband

processing circuit 4

from
Oscillator 8

to capacitor 9

Fig. 4

Fig. 6

from base band
processing circuit 4    11

from oscillator 8

115
116
117
118
119
120

to capacitor 9